# EUROPEAN PATENT APPLICATION

(11) **EP 4 531 082 A1**
(43) Date of publication of application: **02.04.2025**
(21) Application number: 23811538.0
(22) Date of filing: 24.04.2023
(51) Int. Cl.: H01L 21/673

(54) **CONTAINER STORAGE APPARATUS**

(30) Priority: 23.05.2022 JP 2022083746
(71) Applicant: Murata Machinery, Ltd., Kyoto-shi, Kyoto 601-8326 (JP)
(72) Inventor: ITO, Yasuhisa, Inuyama-shi, Aichi 484-8502 (JP)
(74) Representative: Zimmermann, Tankred Klaus
(86) International application number: PCT/JP2023/016103
(87) International publication number: WO 2023/228660

(57) **Abstract**

[Problem] To provide a container storage apparatus capable of sucking gas leaking from a lid of a container with a simpler configuration than conventional ones.

[Means to Solve Problem] A container storage apparatus 10 comprises: a mounting table 20 on which a container 1 having a lid 1c on a side face thereof is mounted; a purger 10 that supplies a purge gas to the container 1; and a sucker 30 that sucks gas leaking from the container 1. The mounting table 20 includes a bottom face 21 on which the container 1 is mounted, and a side wall 23 extending upward from the bottom face and facing the lid of the container mounted on the bottom face. The sucker 30 sucks gas leaking from a side face of the container 1 where the lid 1c is located through a first opening 50 provided in the bottom face 21 or the side wall. An upper end 23 of the side wall 23 is lower than an upper end 1h of the lid 1c of the container 1 mounted on the bottom face 21.

## Description

### Technical Field

The present invention relates to a container storage apparatus.

### Background Art

In semiconductor manufacturing factories, a container storage apparatus for temporarily storing containers that accommodate semiconductor wafers or other items may be provided (for example, see Patent Literature 1). For example, the container storage apparatus may include a purger that supplies a purge gas, such as nitrogen gas, into the container. The container mentioned above is provided with a lid on a side face thereof for opening and closing the opening used for loading and unloading articles, and purge gas may leak from the periphery of the lid. For this reason, the container storage apparatus disclosed in Patent Literature 1 is provided with a sucker that sucks the gas leaking from the lid while the purger supplies purge gas into the container.

### Citation List

### Patent Literature

[Patent Literature 1] Japanese Patent No. 6607314

### Summary of Invention

### Technical Problem

The sucker disclosed in Patent Literature 1 is positioned opposite the lid of each container and has an opening larger than the lid to capture the gas leaking from the lid. As a result, the sucker not only becomes larger in size but also complicates the configuration of the container storage apparatus. Thus, there is a demand for a simpler configuration than conventional ones to suck the gas leaking from the lid.

An object of the present invention is to provide a container storage apparatus capable of sucking gas leaking from a lid of a container, with a simpler configuration than conventional ones.

### Means for Solving Problem

A container storage apparatus according to an aspect of the present invention comprises: a mounting table on which a container having a lid on a side face thereof is mounted; a purger that supplies a purge gas to the container; and a sucker that sucks gas leaking from the container, wherein the mounting table includes a bottom face on which the container is mounted, and a side wall extending upward from the bottom face and facing the lid of the container mounted on the bottom face, wherein the sucker sucks the gas leaking from a side face of the container where the lid is located through a first opening provided in the bottom face or the side wall, and wherein an upper end of the side wall is lower than an upper end of the lid of the container mounted on the bottom face.

### Advantageous Effects of the Invention

According to the container storage apparatus of the above aspect, the sucker can be made smaller compared to conventional suckers that have an opening larger than the lid of the container. Additionally, gas that leaks from the periphery of the lid of the container can be sucked with a simpler configuration than conventional ones.

The mounting table may be capable of mounting thereon a plurality of the containers, the bottom face and the side wall may be formed continuously across the plurality of containers, and a number of the first openings may be less than a number of the containers that can be mounted on the mounting table. According to such a configuration, the number of the first openings may be less than the number of the containers that can be mounted on the mounting table. It is thus possible to reduce the number of components such as covers that cover the first openings and pipes connected to the first openings and simplify the configuration further. The side wall may be provided so as to collectively enclose all four sides of the plurality of containers mounted on the bottom face. According to such a configuration, the side wall encloses a plurality of containers all together. It is thus possible to simplify the configuration further. A height of the upper end of the side wall may be set in a range from 80 mm to 120 mm from the bottom face or a bottom of the container. According to such a configuration, it is possible to suck the gas leaking from the container while keeping the height of the side wall low. The height of the upper end of the side wall may be set in a range from one-fourth to one-third of a height of the container mounted on the bottom face. According to such a configuration, even if the container tilts, the container abuts on the side wall, and thereby the container can be prevented from falling.

The first opening may be provided in the bottom face between the side wall and the container mounted on the bottom face. According to such a configuration, the first opening is arranged below the lid side of the container. It is thus possible to efficiently suck the gas leaking from the periphery of the lid of the container through the first opening. The side wall may be provided so as to enclose all four sides of the container mounted on the bottom face. According to such a configuration, the gas leaking from the container accumulates on the inner side of the side wall. It is thus possible to suppress gas from diffusing below the container storage apparatus.

The sucker may have a second opening provided in the bottom face and a nozzle that releases gas flowing out from an exhaust outlet formed in the bottom of the container to above the bottom face through the second opening and may suck the gas released from the nozzle through the first opening. According to such a configuration, the sucker 30 does not suck the interior of the container. It is thus possible to suppress the interior of the container from becoming a negative pressure. The nozzle may be arranged in a proximity of the first opening. According to such a configuration, the gas leaking from the periphery of the lid of the container and the gas released from the nozzle inside the container can be collectively sucked through the first opening. The mounting table may include a cover that covers the nozzle and the first opening and guides the gas released from the nozzle toward the first opening, and the cover may have a third opening formed in an upper face of the cover and guides the gas flowing in from the third opening toward the first opening. According to such a configuration, while suppressing the diffusion of gas released from the nozzle with the cover, the gas leaking from the container can be sucked through the first opening via the third opening.

### Brief Description of the Drawings

Fig. 1 is a diagram showing an example of a schematic configuration of a container storage apparatus according to an embodiment.
Fig. 2 is a side view of a portion of a container stored in the container storage apparatus.
Fig. 3 is a diagram showing the process of transporting a container to the container storage apparatus.
Fig. 4 is a diagram showing an example of a sucker.
Fig. 5 is a diagram showing an example of a cover.
Fig. 6 is a diagram showing the flow of purge gas.
Fig. 7 is a flowchart showing an example of a container storage method according to the embodiment.
Fig. 8 is a diagram showing a first modified example of the sucker.
Fig. 9 is a diagram showing a second modified example of the sucker.
Fig. 10 is a schematic diagram showing a state of gas in the periphery of a lid of the container in a container storage apparatus according to a comparative example.
Fig. 11 is a schematic diagram showing a state of gas in the periphery of a lid of the container in the container storage apparatus according to the present embodiment.

### Description of Embodiments

Hereinafter, the present invention will be described through an embodiment of the invention. However, the invention defined in the claims is not limited to the following embodiment, and not all combinations of features described in the embodiment are essential to the means by which the present invention solves the above problems. In the drawings, the same or similar members are denoted by the same reference signs, and redundant descriptions may be omitted. Additionally, the shapes and sizes of elements in the drawings may be exaggerated for clarity, and the dimensions and shapes may differ from the actual product. In the following drawings, an XYZ coordinate system is used to describe the directions in each drawing. In the XYZ coordinate system, a plane that is parallel to a horizontal plane is defined as an XY plane. A direction perpendicular to the XY plane is denoted as Z direction. For each of the X direction, the Y direction, and the Z direction, description is made with a definition in which a direction indicated by an arrow is the positive (+) direction and a direction opposite to the direction indicated by the arrow is the negative (-) direction.

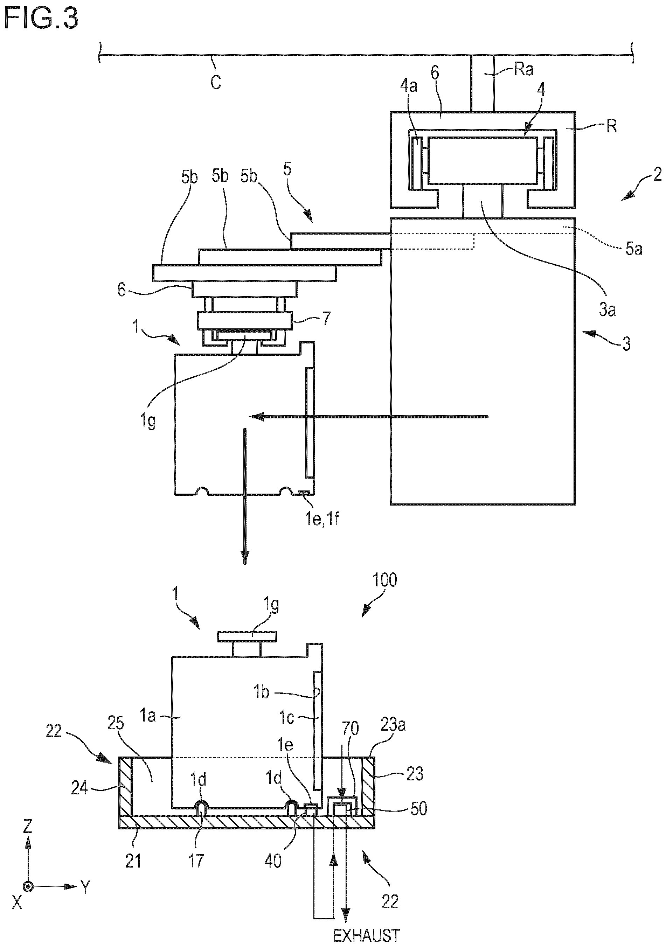

A container storage apparatus 100 can, for example, receive a container 1 being transferred from an overhead transport vehicle 2 transporting the container 1, and is arranged near a ceiling C. The container storage apparatus 100 is fixed in place, suspended from the ceiling C by, for example, suspending brackets, and is arranged near the ceiling C. The container storage apparatus 100 is arranged, for example, at a position laterally offset from directly below the traveling rail (overhead track) R (see Fig. 3) for overhead transport vehicles 2. The container storage apparatus 100 is, for example, a buffer that temporarily stores containers 1 transported by the overhead transport vehicles 2. The container storage apparatus 100 may also be arranged directly below the traveling rail R.

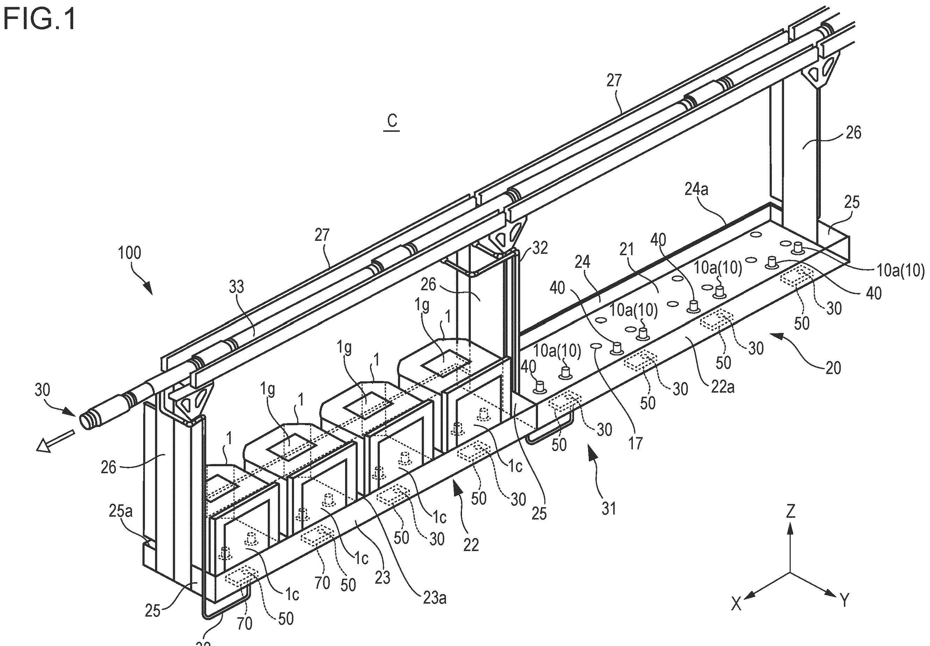

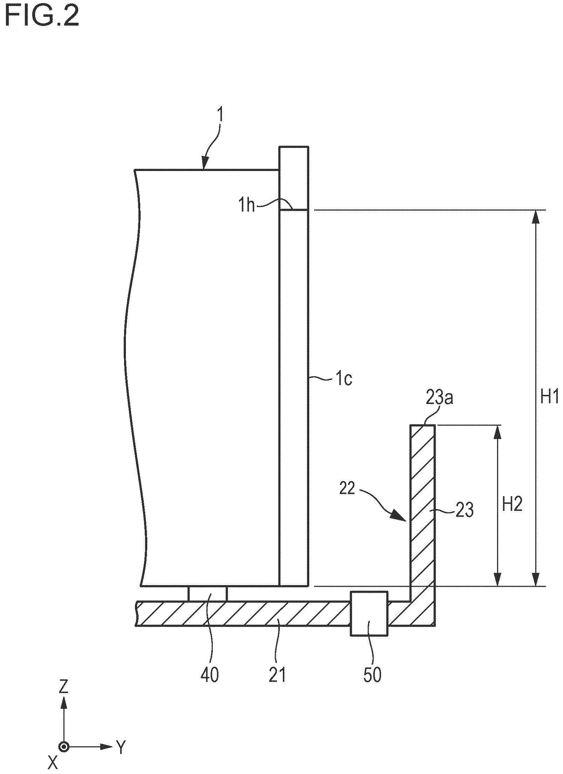

Fig. 1 is a diagram showing an example of a schematic configuration of the container storage apparatus 100 according to the embodiment. Fig. 2 is a side view of a portion of the container 1 stored in the container storage apparatus 100. Fig. 3 is a diagram showing the process of transporting the container 1 to the container storage apparatus 100. As shown in Fig. 1, the container storage apparatus 100 is capable of storing a plurality of containers 1. The container 1 accommodates articles such as wafers and reticles used for manufacturing semiconductor devices. The container 1 is, for example, a FOUP (Front Opening Unified Pod), a SMIF pod, a reticle pod, or the like, the interior of which can be purged with a purge gas. The container 1 may have another form that can be transported by the overhead transport vehicle 2.

As shown in Fig. 2 and Fig. 3, the container 1 includes a main body 1a, an opening 1b, a lid 1c, and a flange 1g. The main body 1a includes recesses 1d formed on the bottom side thereof for positioning. The main body 1a has an inlet 1e for gas and an exhaust outlet 1f for gas on the bottom side. As an example, the inlet 1e and the exhaust outlet 1f are each arranged in the proximity of the end in the X direction on the bottom side of the main body 1a. The inlet 1e and the exhaust outlet 1f each allow communication between the interior and the exterior of the main body 1a. The inlet 1e is used to introduce a purge gas into the main body 1a. The exhaust outlet 1f is used to expel gases within the main body 1a, including the purge gas, from the interior of the main body 1a. The inlet 1e and the exhaust outlet 1f may each be provided with a check valve not shown in the drawings to prevent backflow.

The opening 1b is provided so as to face the horizontal direction (+Y direction). Articles such as wafers are placed inside the container 1 through the opening 1b. For example, the lid 1c is provided for opening and closing the opening 1b and is provided on the container 1 in a detachable manner. Even if the lid 1c is tightly attached to the main body 1a, a gap still remains between the main body 1a and the lid 1c, allowing the possibility of purge gas or other substances leaking from the gap.

A flange 1g, for example, is provided at the top of the container 1. When the container 1 is transported by the overhead transport vehicle 2, the flange 1g is grasped by the overhead transport vehicle 2 for transportation. The container 1 is transported by the overhead transport vehicle 2 from the container storage apparatus 100 to a processing apparatus (not shown in the drawings) and from the processing apparatus to the container storage apparatus 100. This processing apparatus is, for example, a film forming device, a coater/developer, an exposure device, or an etching device, and performs various processes during the manufacturing of devices (for example, semiconductor devices). The container storage apparatus 100 is arranged, for example, on a transport route along which the containers 1 are transported and is used to temporarily store the containers 1.

As shown in Fig. 3, the overhead transport vehicle 2 travels along the traveling rail R by the driving force of a traveler 4. The traveling rail R is arranged in the vicinity of the ceiling C in a state of being suspended from the ceiling C of, for example, a clean room by means of suspending brackets Ra, and extends in the X direction. The overhead transport vehicle 2 includes a main body 3 and the traveler 4. The traveler 4 has wheels 4a, a driving source (not shown in the drawings) such as an electric rotary motor or a linear motor that drives the wheels 4a, and an encoder (not shown in the drawings). The wheels 4a are arranged so as to roll on rail surfaces provided on the inner side of the traveling rail R. The encoder detects the rotation speed of the wheels 4a and outputs the detection results to a controller (not shown in the drawings) included in the main body 3. The controller controls the drive source on the basis of the detection results of the encoder and controls the speed and so forth of the overhead transport vehicle 2.

An upper part of the main body 3 is attached to a coupler 3a extending downward from the traveler 4. The main body 3 is suspended from the traveler 4 via the coupler 3a. The main body 3 is capable of accommodating the container 1 therein. The main body 3 includes a lateral extender 5, an elevator 6, and a grasper 7. The lateral extender 5 is provided on the upper part of the main body 3. The lateral extender 5 changes the state of the container 1 between being accommodated inside the main body 3 and being extended laterally. The lateral extender 5 includes a base 5a and lateral extensions 5b. The base 5a may be provided with a rotary member that has an electric motor or the like and can rotate around the Z direction (vertical direction) being its rotation axis. The rotation of the rotary member causes the lateral extender 5 to rotate, allowing the lateral extension direction of the lateral extender 5 to change.

The lateral extensions 5b are attached to the lower face side of the base 5a. The lateral extensions 5b are, for example, a plurality of movable plates arranged in a manner of being stacked in the Z direction. The plurality of lateral extensions 5b can be moved in the +Y direction or -Y direction (perpendicular to the traveling direction of the traveler 4) along a guide (not shown in the drawings) by the driving force of a power device such as an electric motor (not shown in the drawings). The elevator 6 is attached to the lowermost lateral extension 5b. The lateral extender 5 can move the movable plates, which are the lateral extensions 5b, using a driver and slide the elevator 6 and the grasper 7, which are attached to the lowermost lateral extension 5b, in a direction perpendicular to the traveling direction.

The elevator 6 is controlled by the controller to raise or lower the grasper 7 at a predetermined speed. Also, the elevator 6 is controlled by the controller to maintain the grasper 7 at a target height. The grasper 7 suspends and holds the container 1 by grasping the flange 1c of the container 1. The grasper 7 is, for example, a chuck having claws movable in the horizontal direction. Thus, the overhead transport vehicle 2 can perform lateral transfer to deliver or receive the container 1 to or from a target position in the container storage apparatus 100 by sliding the lateral extensions 5b to laterally extend the elevator 6 and lowering the grasper 7 using the elevator 6. Also, the overhead transport vehicle 2 can deliver or receive the container 1 by lowering the grasper 7 using the elevator 6 without sliding the lateral extensions 5b.

The container storage apparatus 100 includes purgers 10, a mounting table 20, and suckers 30. The purger 10 supplies a purge gas to the container 1 stored in the container storage apparatus 100. The purgers 10 are provided on the mounting table 20. In Fig. 1, the purger 10 is provided for each container 1 stored in the container storage apparatus 100, however, the present invention is not limited to this example. The purger 10 may be provided for some of the containers 1 stored in the container storage apparatus 100.

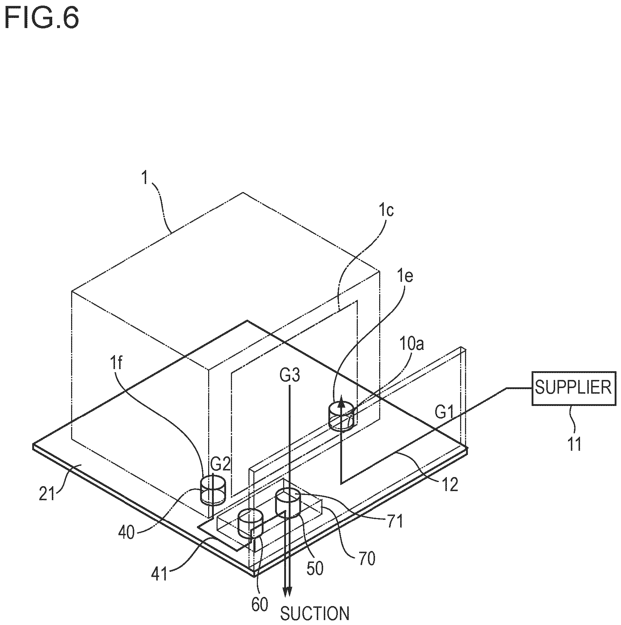

The purger 10 includes, for example, a purge nozzle 10a and a flow rate controller (not shown in the drawings) such as a mass flow controller that controls the flow rate of the purge gas. The purge nozzle 10a is provided in a state of projecting upward from the mounting table 20. The purge nozzle 10a is arranged so as to be connected to the inlet 1e of the container 1 when the container 1 is mounted on the mounting table 20. The purge nozzle 10a is connected to a supplier 11 (see Fig. 6) of the purge gas via a pipe 12 (see Fig. 6), which will be described later. The purge gas is a gas that is inert to the articles stored in the container 1, such as nitrogen gas, for example. The purger 10 supplies the purge gas from the supplier 11 through the pipe 12 to the interior of the container 1 from the inlet 1e and purges the interior of the container 1 with the purge gas.

The mounting table 20 is arranged at a position laterally offset from directly below the track of the overhead transport vehicle 2. The container 1 is mounted on the mounting table 20 from the front side of the container storage apparatus 100 by a lateral transfer performed by the overhead transport vehicle 2. The front side of the container storage apparatus 100 is the side facing the overhead transport vehicle 2. In Fig. 1, the number of mounting tables 20 arranged in the container storage apparatus 100 is two and they are arranged side by side in the X direction, however, the invention is not limited to this example, and one or three or more mounting tables 20 may be arranged in the container storage apparatus 100.

In the present embodiment, a plurality of containers 1 can be mounted on one mounting table 20. However, instead of this configuration, a single mounting table 20 may be configured to allow only one container 1 to be mounted thereon. Fig. 1 shows a state where four containers 1 are mounted on one of the mounting tables 20, and no containers 1 are mounted on the other mounting table 20. The mounting tables 20 may be arranged in parallel instead of being arranged in series in the X direction.

The mounting table 20 includes a bottom face 21, a side wall 22, support columns 26, and a frame 27. The container 1 is to be mounted on the bottom face 21. A plurality of pins (kinematic pins) 17 for positioning the container 1 are provided on the bottom face 21. The pins 17 are arranged so as to correspond to the positions of the recesses 1d provided in the bottom of the container 1 and can fit into the recesses 1d. When the container 1 is mounted on the bottom face 21, the pins 17 fit into the recesses 1d of the container 1, thereby positioning the container 1. The shape and number of the recesses 1d and the pins 17 are arbitrary.

The side wall 22 is provided so as to enclose all four sides of one or more containers 1 mounted on the bottom face 21. The side wall 22 is provided so as to extend vertically upward from the bottom face 21. The side wall 22 is, for example, a plate-shaped member that encloses the periphery of the containers 1. The side wall 22 includes a first side wall 23, a second side wall 24, and a pair of third side walls 25. The first side wall 23 extends upward from the bottom face 21 and faces the lid 1c of the container 1 mounted on the bottom face 21. The first side wall 23 is provided on the front side of the container storage apparatus 100. It should be noted that when the mounting table 20 is capable of storing a plurality of containers 1, the first side wall 23 may be formed continuously across the range corresponding to the plurality of containers 1. However, the invention is not limited to this example, and the first side wall 23 may be provided for each container 1.

An upper end 23a of the first side wall 23 is lower than an upper end 1h of the lid 1c of the container 1 mounted on the bottom face 21. A height H2 of the upper end 23a of the first side wall 23 is lower than a height H1 of the upper end 1h of the lid 1c. As shown in Fig. 2, the height H1 and the height H2 may be heights from the bottom of the container 1 or may be heights from the bottom face 21. The upper end 23a of the first side wall 23 is set in a range from 80 mm to 120 mm from the bottom of the container 1 or the bottom face 21.

The height of the upper end 23 of the side wall 23 may be set in a range from one-fourth to one-third of the height of the container 1 mounted on the bottom face 21. As a result of setting the height of the first side wall 23 in this manner, the gas leaking from the container 1 is suppressed from falling downward from the bottom face 21, and even if the container 1 tilts, the container 1 will be restrained as it abuts on the upper end 23a of the first side wall 23, an upper end 24a of the second side wall 24, or an upper end 25a of the third side wall 25. It is thus possible to prevent the container 1 mounted on the bottom face 21 from falling from the bottom face 21. Moreover, even if the lid 1c inadvertently comes off from the container 1 in storage, the lid 1c will be restrained as it abuts on the upper end 23a of the first side wall 23. It is thus possible to prevent the lid 1c from falling off.

The second side wall 24 is provided on the rear side, opposite the front side of the container storage apparatus 100. In other words, the second side wall 24 is provided on the side opposite the front side, where the front is defined as the face facing the overhead transport vehicle 2. The height of the upper end 24a of the second side wall 24 may be approximately the same as the height of the container 1 mounted on the bottom face 21 or may be a different height. The height of the upper end 24a of the second side wall 24 may be the same as the height of the upper end 23a of the first side wall 23. The second side wall 24 has the function of preventing the gas leaking from the container 1 from flowing around to the rear side and falling downward from the bottom face 21, while also preventing the container 1 mounted on the bottom face 21 from falling off the bottom face 21.

The third side walls 25 are provided on the left and right sides of the container storage apparatus 100, that is, on both ends of the container storage apparatus 100 in the X direction. The third side walls 25, along with the support columns 26 described later, are provided on the +X side and -X side of the container 1. The third side walls 25 are provided so as to connect ends of the first side wall 23 to ends of the second side wall 24. As a result, the ends of the first side wall 23, the second side wall 24, and the pair of third side walls 25 enclose the plurality of containers 1. By enclosing the container 1 with the side wall 22, the gas leaking from the periphery of the lid 1c of the container 1 can be collected on the inner side of the side wall 22, thereby preventing it from diffusing downward.

The ends of the first side wall 23, the second side wall 24, and the pair of third side walls 25 are arranged so as to coincide with the outer edge of the mounting table 20 in a plan view. The height of the upper ends 25a of the third side walls 25 may be approximately the same as the height of the container 1 mounted on the bottom face 21 or may be a different height. The height of the upper ends 25a of the third side walls 25 may be the same as the height of the upper end 23a of the first side wall 23.

The support columns 26 are provided on the +X side and the -X side of the mounting table 20 and support the mounting table 20. The support columns 26 are connected to the bottom face 21, and as described above, a part of each support column 26 is used as a part of the third side wall 25. The frame 27 is provided at the upper ends of the support columns 26 so as to connect the two support columns 26 together. The frame 27 is arranged above the bottom face 21 and extends in the X direction. The frame 27 is suspended from the ceiling C by suspending brackets not shown in the drawings. By adjusting these suspending brackets, the height position of the frame 27 (container storage apparatus 100) can be adjusted.

The sucker 30 sucks the purge gas leaking from the periphery of the lid 1c of the container 1. Here, the purge gas purged into the container 1 may, in some cases, leak from the attachment part or other parts of the lid 1c of the container 1. The purge gas may affect human health, depending on the type or concentration of the gas. In the case where the container 1 is stored in an open environment, the purge gas leaking from the container 1 may cause deterioration of the surrounding environment. In particular, when an operator is working near the container 1, the concentration of the purge gas leaking from the container 1 may increase in the atmosphere around the container 1. Also, in a clean room, a so-called downflow, an air current in which clean air flows downward from a fan filter unit arranged in an upper part of the building, may be present, and if the container 1 is stored in an open environment, the downflow may cause the purge gas to flow toward the ground, resulting in the increased purge gas concentration near the ground. The sucker 30 according to the present embodiment sucks and recovers the purge gas leaking from the container 1 and prevents the purge gas from diffusing around the container storage apparatus 100 or near the ground.

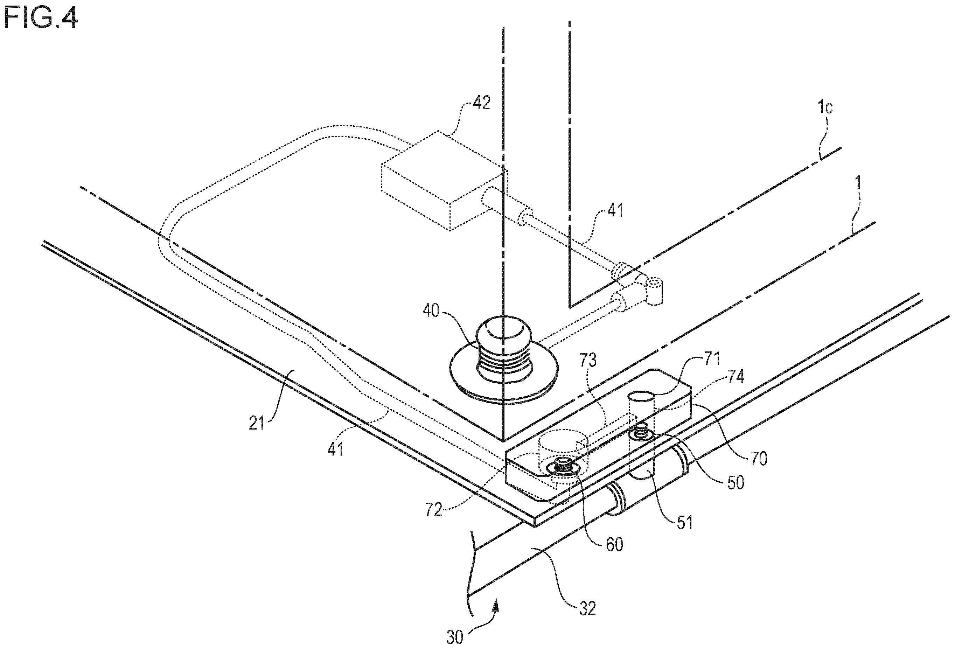

The sucker 30 sucks the gas (including purge gas) leaking from the periphery of the lid 1c of the container 1. The sucker 30 also sucks the gas released from the interior of the container 1 through an exhaust nozzle 40. The exhaust nozzle 40 will be described later. The sucker 30 discharges the sucked gas from the container storage apparatus 100. Fig. 4 is a diagram showing an example of the sucker 30. As shown in Fig. 4, the sucker 30 includes a suction portion 31, a pipe 32, and a pipe 33. The suction portion 31 includes the exhaust nozzle 40, a pipe 41, a flow rate measurer 42, a first nozzle 50, a second nozzle 60, and a cover 70. In the example shown in Fig. 1, the suction portion 31 is provided for each container 1. However, the invention is not limited to this example, and the suction portion 31 may be provided for each set of multiple containers 1.

When the purger 10 supplies the purge gas into the container 1 from the purge nozzle 10a through the inlet 1e of the container 1, the exhaust nozzle 40 releases the gas in the container 1 through the exhaust outlet 1f of the container 1 (see Fig. 6). The exhaust nozzle 40 is provided on the bottom face 21 so as to be connected to the exhaust outlet 1f of the container 1 when the container 1 is mounted on the mounting table 20. The gas in the interior of the container 1 flows out of the container 1 through the exhaust nozzle 40 and is sucked by the sucker 30. The exhaust nozzle 40 is an example of the second opening.

The pipe 41 is provided, for example, on the back side of the bottom face 21. One end of the pipe 41 is connected to the exhaust nozzle 40 and the other end is connected to the second nozzle 60. The flow rate measurer 42 is provided, for example, on the back side of the bottom face 21. The flow rate measurer 42 is provided midway through the pipe 41 and measures the flow rate of the gas discharged from the exhaust nozzle 40 and flowing through the pipe 41. The flow rate measurer 42 may be, for example, a mass flow controller or the like.

The first nozzle 50 is provided, for example, on the bottom face 21 or in the bottom face 21. The first nozzle 50 is provided on the bottom face 21 between the first side wall 23 and the container 1 mounted on the bottom face 21. The first nozzle 50 is arranged inside the cover 70 attached to the bottom face 21. The first nozzle 50 sends the gas inside the cover 70 to the pipe 32 through a connection 51 such as a joint. The connection 51 allows communication between the first nozzle 50 and the pipe 32. The first nozzle 50 projects upward from the upper surface of the bottom face 21 inside the cover 70. The first nozzle 50 may be provided with a check valve to prevent backflow of the gas. It should be noted that the exhaust nozzle 50 is an example of the first opening.

The second nozzle 60 is provided on the bottom face 21. The second nozzle 60 is provided on the bottom face 21 between the first side wall 23 and the container 1 mounted on the bottom face 21. The second nozzle 60 projects upward from the upper surface of the bottom face 21 inside the cover 70. The second nozzle 60 is arranged in the vicinity of the first nozzle 50. The first nozzle 50 and the second nozzle 60 are arranged in line along the X direction, for example. The second nozzle 60 may be provided with a check valve to prevent backflow of the gas. The second nozzle 60 releases the gas flowing out from the exhaust outlet 1f on the bottom of the container 1 toward above the bottom face 21 via the exhaust nozzle 40.

The second nozzle 60 communicates with the pipe 41 and releases the gas flowing through the pipe 41 into the cover 70. The cover 70 is provided on the bottom face 21 between the first side wall 23 and the container 1 mounted on the bottom face 21. The cover 70 is provided so as to cover the first nozzle 50 and the second nozzle 60. The cover 70 guides the gas released from the second nozzle 60 to flow into the pipe 32 through the first nozzle 50. In other words, the cover 70 guides the gas released from the second nozzle 60 toward the first nozzle 50.

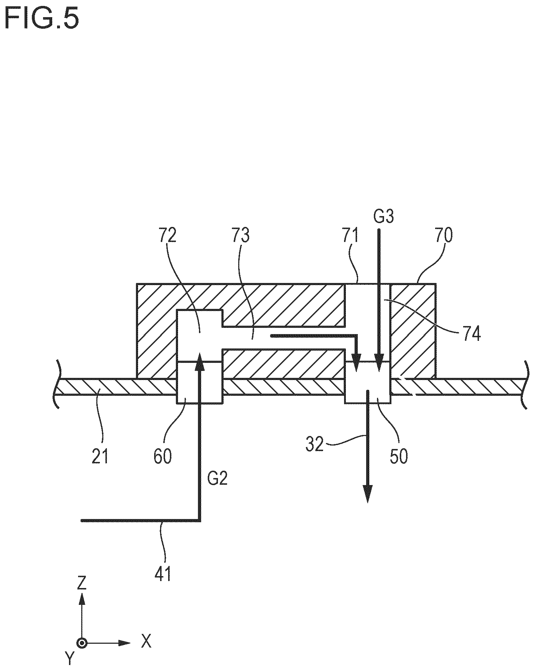

Fig. 5 is a diagram showing an example of the cover 70. As shown in Fig. 5, for example, the cover 70 includes a third opening 71, a first space 72, a second space 73, and a third space 74. The third opening 71 is formed in the upper face of the cover 70. The third opening 71 is a circular hole, however, the shape thereof is not particularly limited. The third opening 71 is a hole for introducing a gas G3 leaking from the periphery of the lid 1c of the container 1 into the cover 70. The upper face of the cover 70 is lower than the upper end 23a of the first side wall 23. That is to say, the third opening 71 is provided at a position lower than the upper end 23a of the first side wall 23. The gas G3 leaking from the periphery of the lid 1c of the container 1 is introduced into the cover 70 through the third opening 71 and is sucked by the first nozzle 50.

The first space 72 is a space inside the cover 70, and a gas G2 from the second nozzle 60 is released thereinto. The first space 72 communicates with the pipe 41 via the second nozzle 60. The first space 72 is, for example, a cylindrical space. The second space 73 connects the first space 72 and the third space 74. The second space 73 guides the gas G2 in the first space 72 to the third space 74. The third space 74 connects the third opening 71 and the first nozzle 50 (first opening). The third space 74 is, for example, a cylindrical space. The third space 74 guides the gas G3 flowing in from the third opening 71 to the first nozzle 50. The third space 74 is connected to the first space 72 via the second space 73. Therefore, the third space 74 guides the gas G2 flowing into the second space 73 from the first space 72 to the first nozzle 50.

Thus, the cover 70 has the function of guiding the gas G2 released from the second nozzle 60 to the first nozzle 50, and the function of guiding the gas G3 leaking from the periphery of the lid 1c of the container 1 from the third opening 71 to the first nozzle 50.

The pipe 32 communicates with the first nozzle 50 via the connection 51. The pipe 32 is connected to the pipe 33 as shown in Fig. 1. It should be noted that Fig. 1 shows a configuration in which one first nozzle 50 and the pipe 32 are connected, and the connections between other first nozzles 50 and pipes 32 are omitted. The gases G2, G3 sucked from the first nozzle 50 are sent to the pipe 33 via the pipe 32. The pipe 32 includes a portion extending in the X direction along the bottom of the bottom face 21 and a portion extending in the Z direction along the support column 26. The pipe 32 is connected to the pipe 33. The pipe 33 is attached to the frame 27. The pipe 33 extends along the frame 27 in the X direction. The gases G2, G3 are sent from the pipe 32 to the pipe 33 and are discharged from the pipe 33 to the outside.

The sucker 30 includes a suction force generator that is connected to the pipe 33 and generates a suction force for sucking the gases G2, G3. However, the invention is not limited to this example, and the sucker 30 may be configured such that the pipe 33 is connected to a suction force generator (line) that is already installed in a factory or the like. In the container storage apparatus 100, the timing of sucking the gases G2, G3 is not particularly limited. For example, suction may be performed in conjunction with the operation of the purger 10. For example, the sucker 30 may start suction at a time when the container 1 is mounted on the bottom face 21 and the purger 10 starts supplying the purge gas to the container 1. Also, the suction of the sucker 30 may be performed continuously without being in conjunction with the purger 10 or may be performed at a timing controlled by the operator.

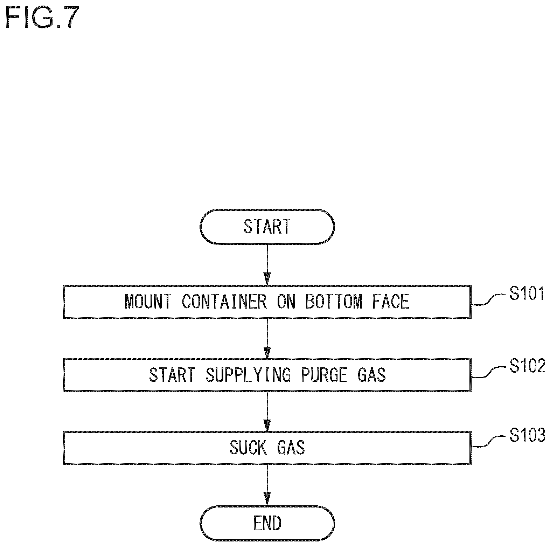

Next, a method for sucking the gases G2, G3 using the sucker 30 will be described, with reference to Fig. 6 and Fig. 7. Fig. 6 is a diagram schematically showing the flows of the purge gases G2, G3 sucked by the sucker 30. Fig. 7 is a flowchart showing an example of a container storage method according to the embodiment. As shown in Fig. 7, the overhead transport vehicle 2 mounts the container 1 at a target position on the bottom face 21 through lateral transfer (Step S101). In Step S101, first, the overhead transport vehicle 2 moves to the container storage apparatus 100 and stops to the side of the target position where the container 1 is to be mounted. Next, the overhead transport vehicle 2 laterally extends the container 1 to directly above the mounting table 20 by means of the lateral extender 5. Next, the overhead transport vehicle 2 lowers the grasper 7 by means of the elevator 6, thereby mounting the container 1 at the target position on the bottom face 21. Next, by releasing the container 1 from the grasp of the grasper 7, the container 1 is mounted on the bottom face 21.

The operation of the overhead transport vehicle 2 is controlled by a controller (not shown in the drawings) included in the overhead transport vehicle 2. This controller acquires information related to the storage location (target position) of the container 1 from a host controller or the like and controls the overhead transport vehicle 2 to mount the container 1 at the storage location. When the container 1 is mounted on the bottom face 21, as described above, the pins 17 provided on the bottom face 21 fit into the recesses 1d provided on the bottom of the container 1, thereby positioning the container 1 on the mounting table 20.

Next, the supply of a purge gas G1 to the container 1 mounted on the bottom face 21 is started (Step S102). In Step S102, when the container 1 is mounted on the bottom face 21, the inlet 1e provided on the bottom of the container 1 and the purge nozzle 10a provided on the bottom face 21 are connected to each other. In this state, the purger 10 supplies the purge gas G1 sent from the supplier 11 into the container 1 via the pipe 12 and the purge nozzle 10a, as shown in Fig. 6. The supply amount of the purge gas G1 is controlled by a controller (not shown in the drawings) included in the purger 10 on the basis of the flow rate of the purge gas G1 flowing through the pipe 12, for example.

When the supply of the purge gas G1 performed by the purger 10 is started, the sucker 30 starts sucking gas (Step S103). When the container 1 is mounted on the bottom face 21, the exhaust outlet 1f provided on the bottom of the container 1 and the exhaust nozzle 40 provided on the bottom face 21 are connected to each other. When the purge gas G1 is supplied into the container 1 in Step S102, the internal pressure of the container 1 increases. As a result of the increase in the internal pressure in the container 1, the gas G2 in the container 1 is discharged from the exhaust outlet 1f and is released from the second nozzle 60 into the cover 70 through the exhaust nozzle 40 and the pipe 41. In Step S103, the gas G2 released into the cover 70 is sucked through the first nozzle 50.

When the internal pressure in the container 1 increases as a result of the supply of the purge gas to the container 1, the gas G3 may leak from the periphery of the lid 1c of the container 1. The gas G3 accumulates on the inner side of the side wall 22 enclosing the container 1 and is sucked from the first nozzle 50 through the third opening 71 of the cover 70. The gases G2, G3 sucked by the first nozzle 50 are discharged through the pipes 32, 33 to the outside of the container storage apparatus 100 (or to the outside of the factory building). It should be noted that the suction of the gases G2, G3 performed by the sucker 30 may be performed when the purge gas is supplied to the container 1 or may be performed continuously while the container 1 is in storage. While the container 1 is stored in the container storage apparatus 100, the sucker 30 may be operated at predetermined intervals on the basis of the output of a timer (not shown in the drawings) or a similar device. The process is concluded through the series of operations described above.

As described above, according to the present embodiment, the sucker 30 does not have an opening larger than the lid 1c of the container 1, and thus the sucker 30 can be made smaller and configured in a simpler manner to suck the gases G2, G3 leaking from the container 1. The upper end 23a of the first side wall 23 is lower than the upper end of the lid 1c of the container 1 mounted on the bottom face 21, and it is thus possible to reduce the amount of vertical movement of the grasper 7 during lateral transfer of the container 1 on the overhead transport vehicle 2. The container 1 is transferred to and from the container storage apparatus 100 through the lateral transfer of the overhead transport vehicle 2 as described above. Therefore, when a sucker with an upper end positioned higher than the lid 1c of the container 1 is arranged, during lateral transfer by the overhead transport vehicle 2, it is necessary to laterally extend the grasper 7 and the container 1 while avoiding the sucker, and to raise or lower them with a long stroke using the elevator 6. In the present embodiment, the upper end 23a of the first side wall 23 is lower than the upper end 1h of the lid 1c of the container 1 mounted on the bottom face 21, and it is thus possible to reduce the amount of vertical movement of the grasper 7 during lateral transfer of the container 1, allowing the container 1 to be transferred efficiently.

Since the side wall 22 is provided to enclose the container 1, the gas G3 leaking from the periphery of the lid 1c of the container 1 accumulates on the inner side of the side wall 22 and is sucked by the first nozzle 50. This suppresses the gases G2, G3 from diffusing into the operator's area of activity below the mounting table 20. Moreover, the first nozzle 50 (the third opening 71 of the cover 70) is provided on the bottom face 21 between the side face of the container 1 on the lid 1c side and the first side wall 23. Thus, the fist nozzle 50 is closer to the lid 1c of the container 1, and this enables efficient suction of the gas G3 leaking from the periphery of the lid 1c of the container 1 through the first nozzle 50. The gas G2 is discharged from the exhaust outlet 1f when the purge gas G1 is supplied to the container 1 along with the gas G3 leaked from the periphery of the lid 1c of the container 1. This eliminates the need for a gas recovery device or a similar device to recover the gas G2 discharged from the exhaust outlet 1f, thereby reducing the manufacturing cost of the container storage apparatus 100.

The container storage apparatus 100 is typically installed in a clean room in which a downflow is present. Therefore, due to this downflow, the gas G3 leaking from the periphery of the lid 1c of the container 1 accumulates more efficiently on the inner side of the side wall 22 and is sucked through the first nozzle 50.

### First Modified Example

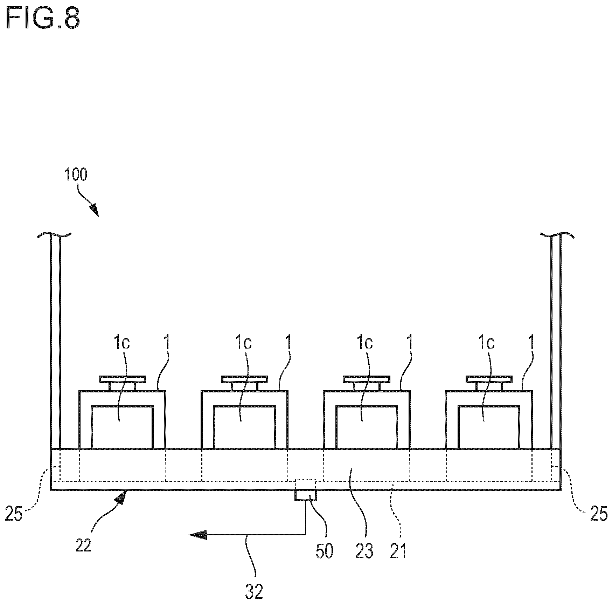

In the above embodiment, an example has been described in which the first nozzle 50 (first opening) is provided for each container 1 mounted on the bottom face 21. However, the invention is not limited to this example. Fig. 8 is a diagram showing a first modified example of the sucker 30. In Fig. 8, the configurations similar to those in the above embodiment are assigned with the same reference signs and the descriptions thereof are omitted or simplified. As shown in Fig. 8, the number of first nozzles 50 may be less than the number of containers 1 mounted on the bottom face 21. For example, one first nozzle 50 may be provided on the bottom face 21 for multiple containers 1. In such a case, the side wall 22 is provided so as to enclose the multiple containers 1, and one first nozzle 50 is provided on the inner side of the side wall 22. Therefore, the gas G3 leaking from the periphery of the lid 1c of each of the multiple containers 1 is collectively accumulated on the inner side of the side wall 22. The cover 70 is provided on the inner side of the side wall 22, with one cover corresponding to one first nozzle 50.

In the case where a single first nozzle 50 is provided for multiple containers 1, for example, the pipe 41 is connected from each exhaust nozzle 40 of the multiple containers 1 to a single second nozzle 60, and the gas G2 from the multiple containers 1 is sent collectively to the one second nozzle 60 and then released into the cover 70. The single first nozzle 50 sucks the gas G3 accumulated on the inner side of the side wall 22 and the gas G2 released into the cover 70 and discharges them to the outside.

Thus, according to the first modified example, it provides the effects similar to those of the above embodiment, and the gases G2, G3 from multiple containers 1 are sucked by fewer first nozzles 50 than the number of containers 1. It is thus possible, compared to the above embodiment, to reduce the number of the first nozzles 50, the pipes 32, and other associated components, and the manufacturing cost of the container storage apparatus 100.

### Second Modified Example

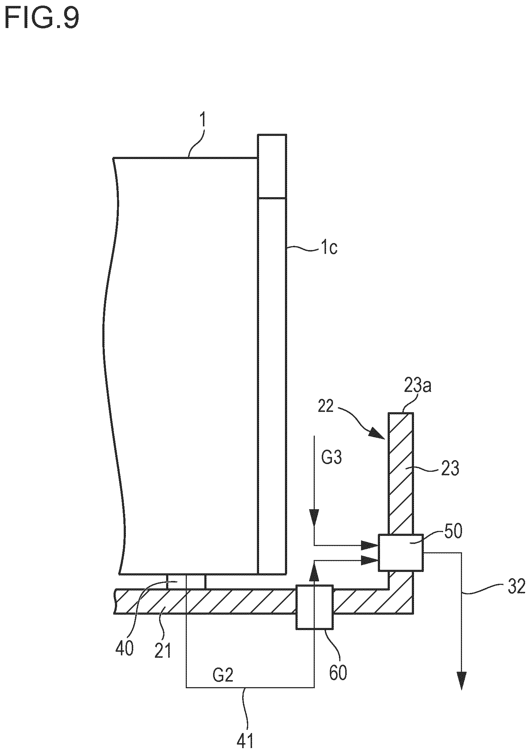

In the above embodiment, an example has been described in which the first nozzle 50 serving as the first opening is provided in the bottom face 21. However, the invention is not limited to this example. Fig. 9 is a diagram showing a second modified example of the sucker 30. In Fig. 9, the configurations similar to those in the above embodiment are assigned with the same reference signs and the descriptions thereof are omitted or simplified. As shown in Fig. 9, the first nozzle 50 (first opening) may be provided in the first side wall 23 instead of the bottom face 21. It is preferable that the first nozzle 50 be provided in a lower part of the first sidewall 23 near the bottom face 21. It should be noted that the number of first nozzles 50 in the second modified example may be less than the number of containers 1 mounted on the mounting table 20, as in the above first modified example.

The second nozzle 60 is provided in the bottom face 21 so as to release the gas G2 upward, for example. A cover or the like may be provided above the second nozzle 60 to block the flow of the gas G2. The gas G2 sent from the exhaust nozzle 40 is released from the second nozzle 60 toward above the bottom face 21 and accumulated on the inner side of the side wall 22. The gas G3 leaking from the periphery of the lid 1c of the container 1 is also accumulated on the inner side of the side wall 22 in a similar manner. The first nozzle 50 sucks the gases G2, G3 accumulated on the inner side of the side wall 22 and discharges them to the outside.

Thus, according to the second modified example, it provides the effects similar to those of the above embodiment. Since the first nozzle 50 is provided in the side wall 22, even if there is no space for the first nozzle 50 to be arranged in the bottom face 21, it is still possible to reliably suck the gases G2, G3 accumulating on the inner side of the side wall 22.

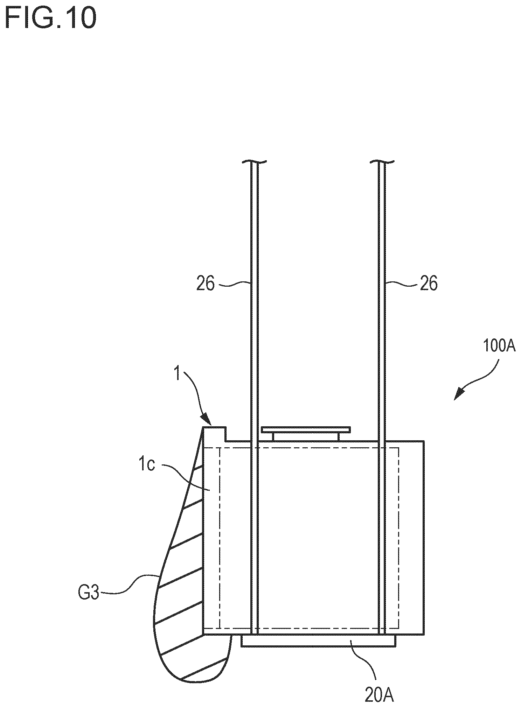

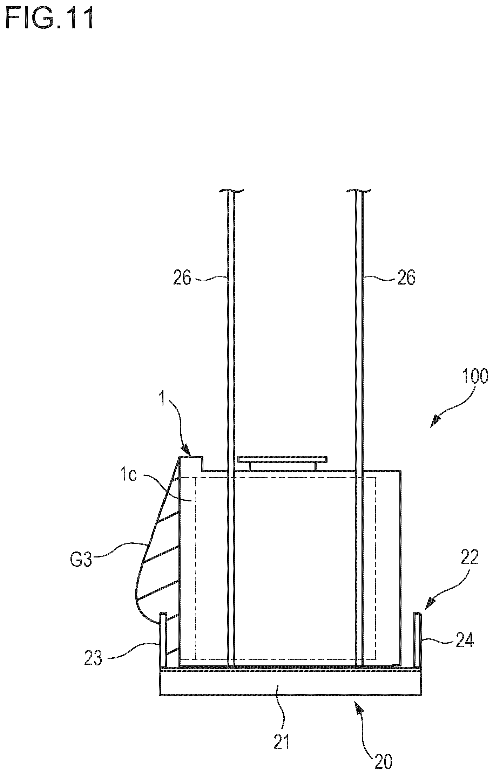

Next, a method for sucking the gas G3 using the sucker 30 will be described, with reference to Fig. 10 and Fig. 11. Fig. 10 is a schematic diagram showing a state of the gas G3 in the periphery of the lid 1c of the container 1 stored in a container storage apparatus 100A according to a comparative example. Fig. 11 is a schematic diagram showing a state of the gas G3 in the periphery of the lid 1c of the container 1 stored in the container storage apparatus 100 according to the embodiment. Fig. 10 and Fig. 11 show a state of the gas G3 in an environment where a downflow is present.

As shown in Fig. 10, the container storage apparatus 100A according to the comparative example does not have a configuration corresponding to the sucker 30. Therefore, as shown in Fig. 10, the gas G3 leaking from the periphery of the lid 1c of the container 1 diffuses so as to spread along the lower side of a mounting table 20A, on which the container 1 is mounted. On the other hand, since the container storage apparatus 100 of the present embodiment includes the side wall 22, the gas G3 leaking from the periphery of the lid 1c of the container 1 is guided to the region between the lid 1c and the first side wall 23 and accumulates on the inner side of the side wall 22.

The gas G3 accumulated on the inner side of the side wall 22 is sucked through the first nozzle 50. It should be noted that illustration of the first nozzle 50 is omitted in Fig. 11. Therefore, the gas G3 diffusing downward from the side wall 22 to the outer side is drawn to the inner side of the side wall 22, thereby preventing the gas G3 from diffusing downward from the bottom face 21. As a result, according to the present embodiment, it is confirmed that the diffusion of the gas G3 below the container storage apparatus 100 is suppressed.

The embodiment has been described above. However, the technical scope of the invention is not limited to the description of the above embodiment. It is also apparent to those skilled in the art that various modifications or improvements can be added to the above embodiment. It is also apparent from the scope of claims that the present invention also encompasses one or more of such modifications or improvements. One or more of the requirements described in the above embodiment may be omitted in some cases. One or more of the requirements described in the above embodiment may be combined where appropriate. The order of executing procedures shown in the present embodiment can be implemented in an arbitrary order unless the result of the previous procedure is used in the following procedure. While operations in the above embodiment have been described with expressions such as "first", "next", and "subsequently" for the sake of convenience, the operations need not always be implemented in that order. The contents of Japanese Patent Application No. 2022-083746 and all documents cited in the detailed description of the present invention are incorporated herein by reference to the extent permitted by law.

### Description of Reference Signs

- C:: Ceiling
- R:: Rail
- 1:: Container
- 2:: Overhead transport vehicle
- 10:: Purger
- 20:: Mounting table
- 30:: Sucker
- 21:: Bottom face
- 22:: Side wall
- 40:: Exhaust nozzle (second opening)
- 50:: First nozzle (first opening)
- 60:: Second nozzle (nozzle)
- 70:: Cover
- 71:: Third opening
- 100:: Container storage apparatus

## Claims

1. A container storage apparatus comprising:
a mounting table on which a container having a lid on a side face thereof is mounted;
a purger that supplies a purge gas to the container; and
a sucker that sucks gas leaking from the container,
wherein the mounting table includes a bottom face on which the container is mounted, and a side wall extending upward from the bottom face and facing the lid of the container mounted on the bottom face,
wherein the sucker sucks gas leaking from a side face of the container where the lid is located through a first opening provided in the bottom face or the side wall, and
wherein an upper end of the side wall is lower than an upper end of the lid of the container mounted on the bottom face.

2. The container storage apparatus according to claim 1,
wherein the mounting table is capable of mounting thereon a plurality of the containers,
wherein the bottom face and the side wall are formed continuously across the plurality of containers, and
wherein a number of the first openings is less than a number of the containers that can be mounted on the mounting table.

3. The container storage apparatus according to claim 2,
wherein the side wall is provided so as to collectively enclose all four sides of the plurality of containers mounted on the bottom face.

4. The container storage apparatus according to claim 1,
wherein a height of the upper end of the side wall is set in a range from 80 mm to 120 mm from the bottom face or a bottom of the container.

5. The container storage apparatus according to claim 1,
wherein the height of the upper end of the side wall is set in a range from one-fourth to one-third of a height of the container mounted on the bottom face.

6. The container storage apparatus according to claim 1,
wherein the first opening is provided in the bottom face between the side wall and the container mounted on the bottom face.

7. The container storage apparatus according to claim 1,
wherein the side wall is provided so as to enclose all four sides of the container mounted on the bottom face.

8. The container storage apparatus according to claim 1,
wherein the sucker has a second opening provided in the bottom face and a nozzle that releases gas flowing out from an exhaust port formed in the bottom of the container to above the bottom face through the second opening, and sucks the gas released from the nozzle through the first opening.

9. The container storage apparatus according to claim 8,
wherein the nozzle is arranged in a proximity of the first opening.

10. The container storage apparatus according to claim 9,
wherein the mounting table includes a cover that covers the nozzle and the first opening and guides the gas released from the nozzle toward the first opening, and
wherein the cover has a third opening formed in an upper face of the cover, and guides the gas flowing in from the third opening toward the first opening.
